(19) Europäisches Patentamt / European Patent Office / Office européen des brevets

(11) **EP 3 540 949 A1**

(12) **EUROPEAN PATENT APPLICATION**

(43) Date of publication:
**18.09.2019 Bulletin 2019/38**

(51) Int Cl.:
*H03M 13/11* (2006.01)     *H03M 13/37* (2006.01)

(21) Application number: **18305269.5**

(22) Date of filing: **13.03.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Universite De Bretagne Sud
56100 Lorient (FR)**

• **Utah State University
Logan, UT 84322-1450 (US)**

(72) Inventors:
• **BOUTILLON, Emmanuel
56100 LORIENT (FR)**
• **WINSTEAD, Chris
River Heights, Utah 84321 (US)**

(74) Representative: **Novagraaf Technologies
12 place des Halles Saint Louis
56100 Lorient (FR)**

(54) **BIT FLIPPING DECODING FOR LDPC CODES**

(57)     The invention relates to a method for controlling a variable node of a decoder decoding LDPC codes, said variable node storing a bit of a word, said method comprising, at each iteration of an iterative loop:
- receiving (10) information messages emitted by a plurality of check nodes connected to said variable node according to a decoding structure, each information message indicating whether the check node satisfies a parity check or not,
- deciding (20) if a bit flipping operation is to be applied to the bit of the variable node based on the received information messages, and
- applying (30) a bit flipping operation to the bit of the variable node if a bit flipping operation is decided,
wherein a bit flipping operation is decided when, the number of check nodes satisfying the parity check is above a predetermined flipping threshold, a dedicated flipping threshold being associated to each iteration of the loop.

Figure 1

**Description**

**1. Technical Field**

The present invention relates generally to the field of the decoding of Low-Density parity-Check codes.

**2. Background Art**

During the past two decades, Low Density Parity Check (LDPC) codes have emerged as a crucial component of many communication standards, and are increasingly important in memory technologies. LDPC codes can offer performance close to the Shannon limit for error rates above the decoder's error floor.

The decoding performances of an error correction code can be characterized by the bit error rate (BER) as a function of the signal-to-noise ratio (SNR). This graph is a curve that is generally composed of two parts: a first part wherein the BER rapidly decreases as a function of the SNR and a second part wherein the BER decreases sharply much more slowly (the slope of the curve is lower). This second part corresponds to a zone wherein the decoder reaches an error rate floor.

This sharp change of slope may be due to some weaknesses of the error correction code and/or to the sub-optimality of the decoding algorithm. In this latter case, it may be useful to change the decoding algorithm in order to reduce, and if possible, eliminate, this error rate floor.

**3. Summary of Invention**

One purpose of present invention is to propose a decoding method that can be used for reducing, and if possible eliminate, this error rate floor. This method may be applied after a first decoding method leading to an error rate floor.

According to the invention, it is proposed to modify the control of the bit flipping operations in the variable nodes of the LDPC decoder in order to achieve this purpose.

Indeed, if a parity check indicates that there is an error in an input data stream (LDPC code to be decoded), the decoder may flip one or more bits of the input data stream that are likely sources of the error in order to correct the data. Bit flipping is commonly performed in the variable nodes of the LDPC decoder and is commonly decided based on reliability metrics computed from channel measurements for the input data stream and parity check results for the estimated codeword.

According to the invention, it is proposed to control the bit flipping operation in a variable node of the LDPC decoder based on parity check results versus different thresholds through the iterative process.

The present invention relates to a method for controlling a variable node of a decoder for decoding LDPC codes, said variable node storing a current bit of a word to be decoded, said method comprising, at each iteration of an iterative loop, the steps of:

- receiving information messages emitted by a plurality of check nodes of said decoder, said check nodes being connected to said variable node in accordance with a predetermined decoding structure, each information message emitted by a check node indicating whether said check node satisfies a predetermined parity check or not,
- deciding if a bit flipping operation is to be applied to the current bit stored in the variable node as a function of the information messages received from the plurality of check nodes connected to said variable node, and
- applying a bit flipping operation to the current bit of the variable node if a bit flipping operation is decided,

wherein a bit flipping operation is decided when, among the plurality of check nodes connected to said variable node, the number of check nodes not satisfying said parity check is above a predetermined flipping threshold, a dedicated predetermined flipping threshold being associated to each iteration of the iterative loop such that the predetermined flipping threshold may change from one iteration to another iteration of said iterative loop.

This method allows reducing the error rate floor by up to a few orders of magnitude.

The present method is applicable to the decoding of LDPC codes including a limited number of errors, for example 10-20 erroneous bits in a code of 2048 bits. That is a reason why the present method is advantageously used after a first decoding method, this latter having corrected a large number of errors or most of the errors but stagnating at an error rate floor. In this case, the present method may thus be considered as a post-processing method.

According to an embodiment, the iterative loop stops when all the check nodes connected to said variable node satisfy said parity checks or when a number of iterations of said iterative loop exceeds a maximal number of iterations.

According to an embodiment, it comprises at least two successive or parallel iterative loops, each iterative loop having a dedicated maximal number of iterations and dedicated predetermined flipping thresholds.

According to an embodiment, it comprises at least two successive iterative loops, called first and second iterative loops and wherein the first iterative stops when the number of check nodes not satisfying said parity check exceeds a predetermined threshold.

According to an embodiment, a bit flipping operation is also decided as a function of a channel information associated with the current bit to be decoded.

According to an embodiment, the flipping thresholds used in an iterative loop are selected as a function of the number of check nodes of the decoder (Sum(S)) not satisfying said parity check. These check nodes are not necessarily check nodes connected to the considered variable node.

The present invention also relates to a variable node in a decoder decoding Low-Density Parity-Check codes, called LDPC codes, said variable node said variable node storing a current bit of a word to be decoded, said variable node being configured to implement, at each iteration of an iterative loop, the steps of:

- receiving information messages emitted by a plurality of check nodes of said decoder, said check nodes being connected to said variable node in accordance with a predetermined decoding structure, each information message emitted by a check node indicating whether said check node satisfies a predetermined parity check or not,
- deciding if a bit flipping operation is to be applied to the current bit stored in the variable node as a function of the information messages received from the plurality of check nodes connected to said variable node, and
- applying a bit flipping operation to the current bit of the variable node if a bit flipping operation is decided,

characterized in that a bit flipping operation is decided when, among the plurality of check nodes connected to said variable node, the number of check nodes not satisfying said parity check is above a predetermined flipping threshold ($\theta(it)$), a dedicated predetermined flipping threshold being associated to each iteration of the iterative loop such that the predetermined flipping threshold may change from one iteration to another iteration of said iterative loop.

According to an embodiment, the iterative loop stops when all the check nodes connected to said variable node satisfies said parity check or when a number of iterations of said iterative loop exceeds a maximal number of iterations.

According to an embodiment, the variable node is configured to comprise at least two successive or parallel iterative loops, each iterative loop having a dedicated maximal number of iterations and dedicated predetermined flipping thresholds.

According to an embodiment, the variable node is configured to comprise at least two successive iterative loops, called first and second iterative loops, wherein the first iterative stops when the number of check nodes connected to said variable node and not satisfying said parity check exceeds a predetermined threshold.

According to an embodiment, a bit flipping operation is also decided as a function of a channel information associated with the current bit to be decoded.

According to an embodiment, the flipping thresholds used in an iterative loop are selected as a function of the number of check nodes of the decoder not satisfying said parity check. These check nodes are not necessarily check nodes connected to the considered variable node.

The present invention also relates to a decoder for decoding LDPC codewords comprising a plurality of check nodes and a plurality of variable nodes as defined hereinabove.

The present invention also relates to a computer program product comprising program code instructions for implementing the method as defined above, when said program is executed on a computer or a processor

The present invention also relates to a non-transitory computer-readable storage medium storing a computer program product as defined above.

## 4. Brief description of the drawings

The invention can be better understood with reference to the following description and drawings, given by way of example and not limiting the scope of protection, and in which:

- Figure 1 is a flow chart of the successive steps when performing a method for controlling a variable node according to an embodiment of the invention;
- Figure 2 is a schematic view of a variable node connected to a plurality of check nodes;
- Figure 3 shows first graphs illustrating the performances of the method of the invention;
- Figure 4 shows second graphs illustrating the performances of the method of the invention;
- Figure 5 shows third graphs illustrating the performances of the method of the invention;
- Figure 6 is a schematic view of a decoding device comprising variable nodes and check nodes according to one embodiment of the invention; and
- Figure 7 is a schematic view of a variable node according to one embodiment of the invention.

The components in the figures are not necessarily to scale, emphasis instead being placed upon illustrating the principles of the invention.

## 5. Detailed description of preferred embodiments

While example embodiments are capable of various modifications and alternative forms, embodiments thereof are shown by way of example in the drawings and will herein be described in details. It should be understood, however, that there is no intent to limit example embodiments to the particular forms disclosed, but on the contrary, example embodiments are to cover all modifications, equivalents, and alternatives falling within the scope of the claims. Like numbers refer to like elements throughout the description of the figures.

Before discussing example embodiments in more details, it is noted that some example embodiments are described as processes or methods depicted as flowcharts. Although the flowcharts describe the operations as sequential processes, many of the operations may be performed in parallel, concurrently or simultaneously. In addition, the order of operations may be re-arranged. The processes may be terminated when their operations are completed, but may also have additional steps not included in the figures. The processes may correspond to methods, functions, procedures, subroutines, subprograms, etc.

Methods discussed below, some of which are illustrated by the flow charts, may be implemented by hardware, software, firmware, middleware, microcode, hardware description languages, or any combination thereof. When implemented in software, firmware, middleware or microcode, the program code or code segments to perform the necessary tasks may be stored in a machine or computer readable medium such as a storage medium. A processor(s) may perform the necessary tasks. Specific structural and functional details disclosed herein are merely representative for purposes of describing example embodiments of the present invention. This invention may, however, be embodied in many alternate forms and should not be construed as limited to only the embodiments set forth herein.

The terminology used herein is for the purpose of describing particular embodiments only and is not intended to be limiting of example embodiments. As used herein, the singular forms "a", "an" and "the" are intended to include the plural forms as well, unless the context clearly indicates otherwise. It will be further understood that the terms "comprises", "comprising," "includes" and/ or "including", when used herein, specify the presence of stated features, integers, steps, operations, elements and /or components, but do not preclude the presence or addition of one or more other features, integers, steps, operations, elements, components and /or groups thereof. Similarly, it is to be noticed that the term "coupled" should not be interpreted as being restricted to direct connections only. Thus, the scope of the expression "a device A coupled to a device B" should not be limited to devices or systems wherein an output of device A is directly connected to an input of device B. It means that there exists a path between an output of device A and an input of device B which may be a path including other devices or means. Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

The present method discloses a new way of controlling bit flipping in a variable node of a LDPC decoder. This method, called Syndrome Bit Flipping (SBF), ignores, at least in one embodiment, channel information and considers, in this embodiment, only the parity-check results coming from the check nodes connected to the variable nodes.

The present method may be applied to LDPC codes comprising a small number of errors. It is therefore advantageously applied on codes issued from a first decoding method. This first decoding method is for example based on the Noisy Gradient Descent Bit Flipping (NGDBF) algorithm disclosed in the article *"Noisy Gradient Descent Bit-Flip Decoding for LDPC Codes"*, G. Sundararajan, C. Winstead, E. Boutillon, IEEE Transactions on Communications, Volume 62, Issue 10, October 2014, pp. 3385-3400 or based on the Probabilistic Gradient Descent Bit Flipping (PGDBF) algorithm disclosed in *"Fault-Tolerant Probabilistic Gradient-Descent Bit Flipping Decoder"*, O.A. Raheed, P. Ivanis, B. Vasic, IEEE Communications Letters, Volume 18, Issue 9, September 2014, pp. 1487-1490.

In classical bit flipping methods, such as NGDBF or PGDBF, channel information and parity check results are used to decide bit flipping or not. According to the invention, the decision to flip a bit in a variable node of the decoder is taken based on parity check results from the check nodes connected to the considered variable versus predetermined flipping thresholds.

The present invention is detailed hereinafter. A LDPC codeword C of size (n,1) is non-erroneous (includes no error) if and only if $H.C=0_m$ wherein H is a parity-check matrix of size (m,n) and $0_m$ is a vector of null values of size (m,1). The operations of the product H.C are performed in the Galois field GF(2) or, in an equivalent manner, in the set of integers modulo 2.

After transmission and reception, the received word Y may comprise erroneous elements (erroneous bits for binary LDPC codewords). This word Y is not a codeword since it comprises erroneous bits. The word Y may be first decoded by a first decoding method such as NGDBF or BP until an error rate floor is reached. The word issued from this first decoding algorithm is called U and comprises a reduced number of bit errors. We have thus U=C+err, with err(k)=0 if U(k)=C(k) and err(k)=1 if U(k)≠ C(k). It can be considered that, after applying a first decoding method such as NGDBF, the number of residual errors is small in comparison to the number n of elements of the codeword C.

A syndrome vector S comprising all the non-satisfied parity checks (check parity results from the check nodes connected to the variable) is computed:

$$S= H.U = H.(C+err) = H.C + H.err = H.err.$$

The syndrome vector S is of size m. This syndrome vector is depending on the error pattern err. Conversely, the computation E=H'.S, wherein H' is the conjugated matrix of H, gives a vector of size n, in which each component E(k) indicates directly how many parity checks are not satisfied due to the error err(k).

According to the invention, the flipping decision in a variable node is only based on the vector E (E for Energy).

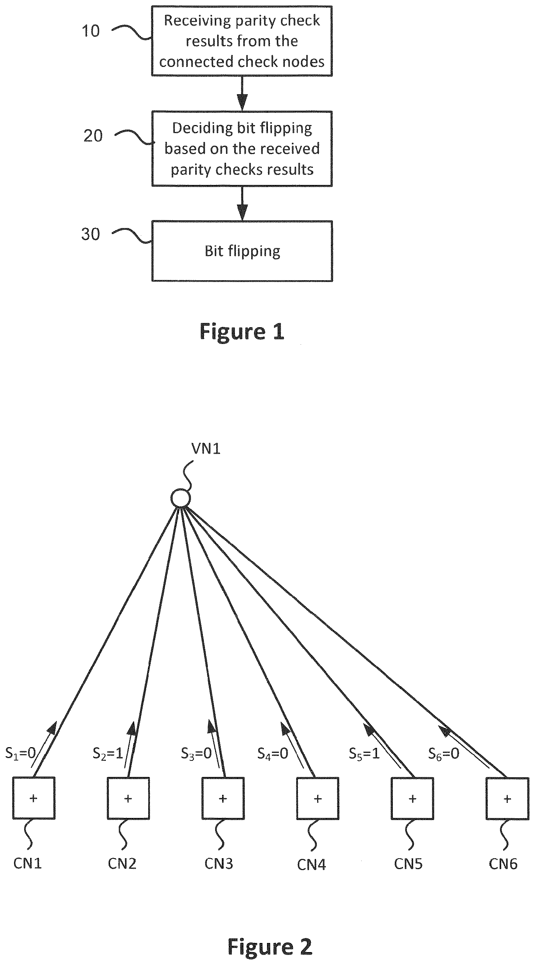

**Figure 1** is a flow chart illustrating the method of the invention. The method is used for controlling a variable node of a decoder. The variable node stores a current bit of a LDPC code to be decoded. The current bit is decoded iteratively. The method comprises, at each iteration of the iterative loop, the following steps of

- Step 10: receiving information messages emitted by a plurality of check nodes of said decoder, said check nodes being connected to said variable node in accordance with a predetermined decoding structure, each information message emitted by a check node indicating whether said check node satisfies a predetermined parity check or not,
- Step 20: deciding if a bit flipping operation is to be applied to the bit stored in the variable node only as a function of the information messages received from the plurality of check nodes connected to said variable node, and
- Step 30: applying a bit flipping operation to the bit of the variable node if a bit flipping operation is decided,

This method may be illustrated for a variable node VN1 as shown in **Figure 2**. The variable node VN1 stores a current bit of a word U to be decoded and is connected to 6 check nodes CN1-CN6. The check nodes are connected to other variable nodes (not shown). The method is iterative and may comprise a maximal number of iterations max_it. The decision of flipping the bit (0→1 or 1→0) stored in the variable node is decided at each iteration as a function of parity check results coming from the check nodes connected to the variable VN1. The parity check result of a check node CNi is noted $S_i$. In the example of Figure 2, check parity is satisfied in the check nodes CN1, CN3, CN4 and CN6 ($S_1=0,S_3=0,S_4=0,S_6=0$) and not satisfied in CN2 and CN5 ($S_2=1,S_5=1$).

In step 10, the variable node VN1 receives the parity check results $S_1$-$S_6$. In step 20, the variable node VN1 decides if a bit flipping is to be applied to its stored bit based on these results. More specifically, the bit flipping is decided based on the number of non-satisfied check parities. In the example of Figure 2, VN1 is connected to 2 check nodes (CN2 and CN5) having non-satisfied check parities ($S_2=1$ and $S_5=1$). This number non-satisfied check parities is compared to a predetermined flipping threshold $\theta$. A dedicated flipping threshold $\theta(it)$ is associated to each iteration number *it* of the iterative decoding loop such that the flipping may change at each iteration of the iterative loop. The decision to flip the bit $x_i$ of the variable node VNi is taken if

$$\sum_{j\in M(i)} S_j > \theta(it).$$

wherein *M(i)* designates the check nodes connected to the variable node VNi and m is the number of elements of *M(i)*.

In Figure 2, M(1) associated to the variable node VN1 comprises m=6 elements and the sum $\sum_{j\in M(1)}^{6} S_j$ is equal to 2. This sum value is then compared to the flipping threshold $\theta(it)$ of the current iteration and if this sum value is above the flipping threshold, a bit flipping is decided.

This process is reiterated with the flipped or not flipped bit value of the variable node VN1 and the flipped or not flipped bit value of the other variable nodes. All the flipped values modify the parity check results of the next iteration.

This iterative process stops when the number of iterations exceeds said maximal number of iterations max_it or when the parity checks of all the check nodes connected to said variable node are satisfied $(\sum_{j\in M(i)}^{m} S_j = 0).$

The above-described method has been tested on different words of 2048 bits (n=2048). The size of the parity check matrix H is (384, 2048). The decoder thus comprises 2048 variable nodes and 384 check nodes. The word to be decoded comprises 20 errors.

In a first example, the word may be decoded in 5 iterations with the predetermined sequence of flipping thresholds [4 4 4 3 3]. The number of residual errors nb_err and the number of non-satisfied check nodes nb_synd is computed at each iteration. The above-described method gives the following results:

| iteration | 1 | 2 | 3 | 4 | 5 | end |
|---|---|---|---|---|---|---|
| Threshold $\theta$ | 4 | 4 | 4 | 3 | 3 | |
| nb_err | 20 | 11 | 6 | 5 | 3 | **0** |
| nb_synd | 92 | 44 | 22 | 18 | 14 | **0** |

In a second example, the same word may be decoded in 7 iterations with the predetermined sequence of flipping thresholds [4 4 4 4 3 3]. The above-described method gives the following results:

| iteration | 1 | 2 | 3 | 4 | 5 | 6 | 7 | end |
|---|---|---|---|---|---|---|---|---|
| Threshold $\theta$ | 4 | 4 | 4 | 4 | 4 | 3 | 3 | |
| nb_err | 20 | 11 | 6 | 5 | 5 | 5 | 3 | **0** |
| nb_synd | 92 | 44 | 22 | 18 | 18 | 18 | 14 | **0** |

In a third example, the decoding fails with the predetermined sequence of flipping thresholds is [3 3 3 3]. The above-described method gives the following results:

| iteration | 1 | 2 | 3 | 4 | **5** |
|---|---|---|---|---|---|
| Threshold $\theta$ | 3 | 3 | 3 | 3 | |
| nb_err | 20 | 54 | 157 | 542 | **941** |
| nb_synd | 92 | 118 | 172 | 206 | **202** |

So these examples show that the predetermined threshold sequence is important. The above examples show that some error patterns may be solved by the sequence [4 4 4 3 3] and not [3 3 3 3]. Conversely, some error patterns may be solved by the sequence [3 3 3 3] and not the sequence [4 4 4 3 3]. So the threshold sequence is a decoding key and each key can resolve a subset of error patterns.

During the decoding process, in an improved embodiment, it is proposed to concatenate a plurality of predetermined threshold sequences in order to apply these sequences one after the other. It is equivalent to perform successively a plurality of iterative loops with dedicated sequences of thresholds. The word to be decoded goes back to its initial value at the beginning of each threshold sequence. For example, in the case of 3 threshold sequences each solving a given subset of patterns such as [5 4 4 2 4 4], [3 3 3 2 4] and [4 4 3 2 3], the resulting sequence may be [5 4 4 2 4 4 **-1** 3 3 3 2 4 **-1** 4 4 3 2 3]. The value $\theta$=-1 indicates that the word must be reinitialised.

The method may be transposed in Matlab as follows:

**Program 1**

```
% Definition of simulation parameters
[m, n] = size(H);
max_it = length(threshold);
nb_err = zeros(1,max_it+1); % number of errors
nb_synd = zeros(1, max_it+1) % number of syndroms
e = err; % Select the k^th error vector to be processed
S = mod(H*e',2); % Computation of syndrome vector based on error vector e.
it = 1;
nb_err(it) = zeros(1,sum(e));
nb_synd(it) = sum(S)
while (it <= max_it) && sum(S) > 0
    E = H'*S; % Computation of the energy vector E
        % E gives the number of non-satisfied checks for each variable node
```

```
if threshold(it) < 0 % a negative value means that a new threshold
                     % sequence is tested
   e = err; % the word is reinitialized
else
    index = find(E > threshold(it));
    e(index) = 1 - e(index); % Flip the bits
end;
  S = mod(H*e',2);
  it = it + 1;
nb_err(it) = sum(e);
nb_synd(it) = sum(S)
end;
```

As a variant, the different iterative loops may also be performed in parallel or in series/parallel.

According to an embodiment, the threshold sequence to be used in the iterative loop may be selected based on the number of check nodes not satisfying the parity check.

According to another embodiment, intermediate states of the variable node during the iterative loop may be stored in order to reduce the processing time with two thresholds sequence beginning by the same thresholds. For example, if the two thresholds sequences [2 3 3 2 4 3 2] and [2 3 3 2 2 3 3] are processed, the intermediate state of the variable node after the 4th cycle of the sequence [2 3 3 2 4 3 2] (obtained after comparison with the first thresholds [2 3 3 2]) is stored in order not to have to re-compute the 4 first cycles for the sequence [2 3 3 2 2 3 3]. In some problematic cases, it can be difficult to find threshold sequences enabling to obtain a word without errors (=codeword). For these cases, it can be therefore useful to adapt the post-processing and to use special "recipes" found empirically. These recipes are solutions found to solve specific trapping sets (blocking situations).

In these recipes, the channel information may be used as an additional parameter to determine the bits to be flipped. More specifically, a channel information reliability value associated to the bit stored in the variable node may be used and compared to a predetermined reliability threshold T.

The recipe to be used may be determined based on the number of check nodes not satisfying the parity check.

For example, according to an embodiment, channel information on the bit to be decoded is introduced in the bit flipping process when the number of check nodes not satisfying the parity check is equal to a given value, for example 8. In that case, the program defined in Matlab may be completed by the following instructions:

**Program 2**

```
if sum(S) == 8
        index = find(((E' == 1).* (abs(y) < T)) > 0); % determination the index of
                      % variable nodes having 1 check node unsatisfied and storing a
                      % bit having a reliability value lower than a reliability threshold T
        x(index) = 1 - x(index); % flip the bit
        [nb_err, nb_synd, xt] = SBF_err(H, x, [2 4]); % application of the SBF algorithm
                                  % with the threshold sequence [2 4]
   if nb_synd(end) > 0 % if still unsatisfied checks, application of the SBF algorithm with
       % the threshold sequence [5 4 4 3 3]
               [nb_err, nb_synd, xt] = SBF_err(H, x, [5 4 4 3 3]);
        end;
    end;
```

The performance of the above described method (SBF for Syndrome Bit Flipping) have been evaluated in comparison to other bit-flipping algorithms. Simulation have been made on a IEEE 802.3an LDPC code defined for the 10 Gbit/s Ethernet Standard as defined in *"IEEE Standard for Ethernet"* IEEE Std. 802.3-2015, 2016. This LDPC code is defined by a parity-check matrix H with size 2048 x 384. It is a regular code with check degree $d_c$= 32 and variable degree $d_v$ = 6. The word is assumed to be received through a Binary Symmetrical Channel (BSC).

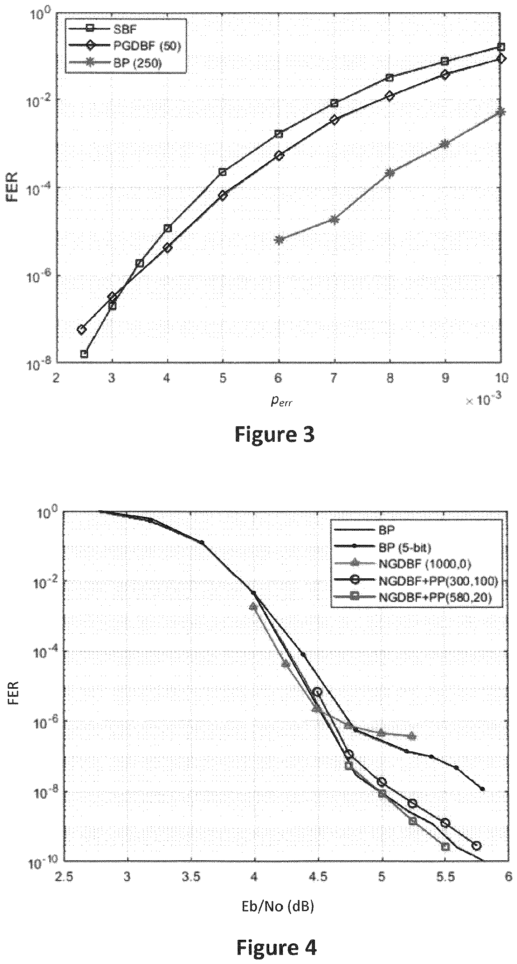

Simulation results are shown in **Figure 3** along with results for the Probabilistic Gradient Descent Bit Flipping (PGDBF) algorithm and the Belief Propagation (BP) algorithm. The curve PGDBF(1000,0) illustrates the results of the algorithm PGDBF after 50 iterations. The curve BP (250) illustrates the results after 250 iterations of the algorithm BP. At frame error rates above $10^{-6}$, SBF shows performance somewhat worse than PGDBF or BP. The improvement of SBF is seen in the error floor region, where the frame error rate approaches $10^{-8}$. In this performance domain, SBF alone performs better than either PGDBF or BP, likely because of its resistance to dominant trapping set errors that affect the other algorithms.

SBF was also simulated as a post-processing phase for the NGDBF on two codes. PP designates Post-Processing which is SBF here. The first code is the IEEE 802.3an LDPC code, simulated on a 5-bit quantized AWGN channel, with results shown in **Figure 4.** Results for quantized BP (5-bit) and unquantized BP are also shown, using data from the article *"Design of ldpc decoders for improved low error rate performance: quantization and algorithm choices"* Z.Zhang, L.Dolecek, B.Nikolic, V.Anantharam, and M.J.Wainwright, IEEE Transactions on Communications, vol.57, no.11, pp. 3258-3268, Nov 2009. The curve NGDBF(1000,0) illustrates the results of the algorithm NGDBF after 1000 iterations and 0 iteration of SBF or PP. The curve NGDBF+PP(300,100) illustrates the results after 300 iterations of the algorithm NGDBF and 100 iterations of SBF or PP.

NGDBF was found to reach an error floor similar to quantized BP at a Frame Error Ratio (FER) of $10^{-6}$. With SBF post-processing, the error floor is lowered to about $10^{-8}$, similar to unquantized BP.

The results also show that the total iterations can be significantly reduced when using SBF, requiring a maximum of four hundred iterations for NGDBF+SBF, whereas NGDBF alone must allow up to 600 iterations to achieve adequate performance on this code. By lowering the maximum iterations from 600 to 400, the decoder's worst case throughput is improved. In the error floor region, the vast majority of frames complete successfully in only a few iterations of NGDBF. Since post-processing is only activated for rare frames, it should not significantly affect the average throughput.

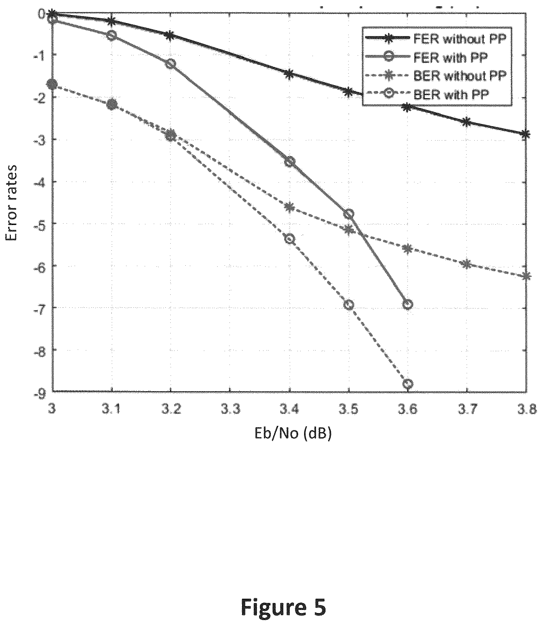

The SBF method was also simulated for a larger code with $d_v$=5 and 10 iterations of NGDBF and 240 iterations of SBF (to be validated) with results shown in **Figure 5.** This code reaches a very high error floor with NGDBF, but the floor is suppressed below an FER of $10^{-6}$ when using NGDBF+SBF.

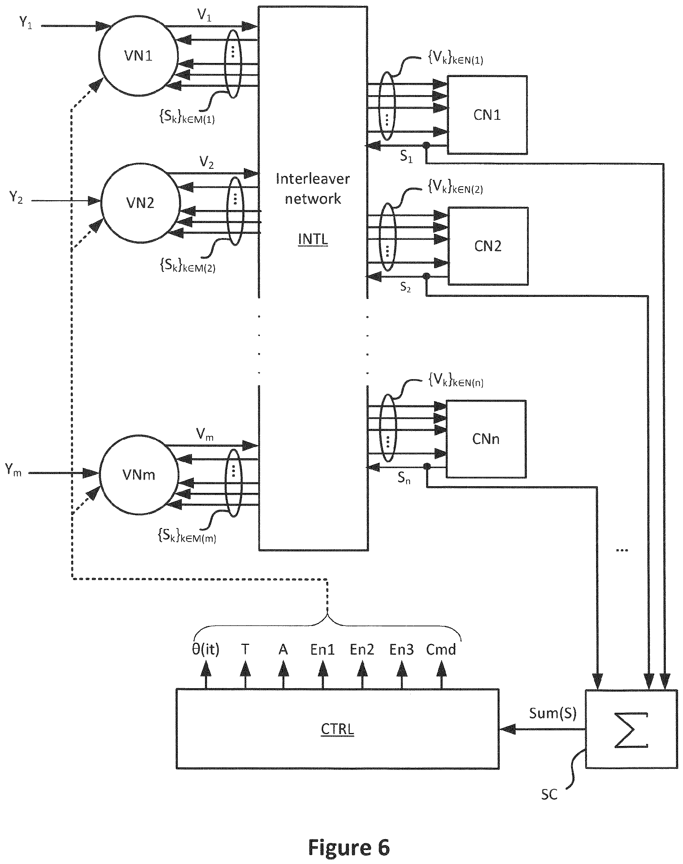

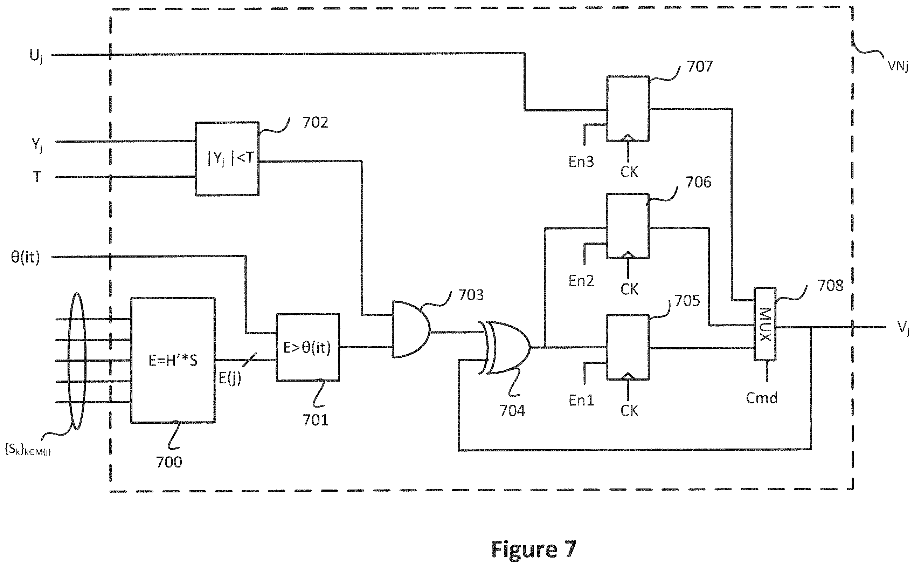

**Figures 6 and 7** are schematic views illustrating respectively a decoding device and a variable node implementing the above-described method.

Figure 6 shows a decoding device comprising a plurality of variable nodes VN1... VNm connected to a plurality of check nodes CN1...CNn via an interleaver network INTL. Each variable node VNj outputs a message $V_i$ and receives parity-check result messages $\{S_k\}_{k \in M(j)}$ from the checks nodes connected to the variable node VNj via the interleaver network. As already mentioned hereinabove, M(j) designates the set of the checks nodes connected to the variable node VNj. Inversely, each check node CNi outputs a parity-check result message Si and receives messages $\{V_k\}_{k \in N(i)}$ from the variable nodes connected to the check node CNi via the interleaver network. N(i) designates the set of the variable nodes connected to the check node CNi.

Each variable node VNj also receives parity-check results $S_j$ from the check nodes connected to it, reliability values Yj issued from channel information, control parameters (En1, En2, En3, Cmd) and threshold parameters ($\theta$(it), T) issued by a control circuit CTRL. At each iteration of an iterative loop, the control circuit CTRL delivers new control or threshold parameters. These parameters will be detailed later.

The decoding device further comprises a sum circuit SC for summing the parity-check results Si and delivers the sum value Sum(S). This value is used by the control circuit CTRL to define the values of the control parameters (En1, En2, En3, Cmd) and threshold parameters ($\theta$(it), T).

With Reference to Figure 7, the variable node VNj comprises the following components:

- a circuit 700 for computing the energy E, noted E(j), from the parity check results $\{S_k\}_{k \in N(i)}$ coming from the check nodes at an iteration *it*;
- a comparator circuit 701 for comparing the energy E(j) with the flipping threshold $\theta$(*it*); the comparator circuit 701 delivers "1" when E(j)> $\theta$(*it*) and "0" else;
- a comparator circuit 702 for comparing the module of a reliability value Yj of an information channel associated to the variable node VNj energy vector E with the reliability threshold *T*; the comparator circuit 702 delivers "1" when $|Y_j|$<T and "0" else; the reliability is predefined and is equal to 5 in Matlab program 2 given previously; the comparator circuit 702 is configured to deliver "1" when it is not used by the SBF algorithm;
- a AND gate 703 connected to the outputs of the comparator circuit 701 and the comparator circuit 702; the AND gate 702 delivers "1" when it receives "1" on its two inputs;
- a X-OR gate 704 receiving on one of its inputs the result of the AND gate 703 and on the other input the result of the output Vj at the previous iteration *it-1* ; the X-OR gate performs the flipping operation on the bit Vj when the AND gate 703 delivers "1";
- a register 705 for storing the result of the flipping operation at the current iteration *it*; the register 705 is enabled by the enable signal En1 delivered by the control circuit CTRL and synchronized by a clock signal CK;
- a register 706 for storing an intermediary result of flipping operation during the processing of a threshold sequence; the register 706 is enabled by the enable signal En2 delivered by the control circuit CTRL and synchronized by the clock signal CK;
- a register 707 for storing, at the beginning of the SBF process, the bit Uj of the word U to be decoded; the bit Uj may be delivered by a first decoding algorithm, such as NGDBF or BP or PGDBF; the register 707 is enabled by the enable signal En3 delivered by the control circuit CTRL and synchronized by the clock signal CK; and

- a multiplexer 708 for selecting the output of one of the registers 705 to 707 as output value Vj for the variable noble VNj; the multiplexer is controlled by the control signal Cmd delivered by the control circuit CTRL.

A brief description of the working of such a variable node is given hereinafter. The SBF algorithm is applied on a word U comprising a reduced number of errors and delivered for example by a first algorithm such as NGDBF or BP. The variable node VNj of Figure 7 is used to decode the bit Uj of the word U. At the beginning of the SBF algorithm, the bit Uj is stored in the register 707 (the signal En3 is ON) and the multiplexer 703 is controlled by the signal cmd to deliver the output of the register 707.

At the first iteration of the SBF algorithm, the bit flipping of the bit Uj stored in the register 707 is decided based on the parameters $\theta$, T and the reliability value Yj.

The control circuit CTRL compares the value Sum(S) to at least one predefined value A (in the above program 2, A=8) and do not activate the comparator circuit 702 if Sum(S) is different from A. The comparator circuit 702 is configured to deliver "1" when not activated by the CTRL circuit. According to the SBF algorithm, when Sum(S) is equal to A, a special recipe associated to the value A (as described in program 2) is applied. Preferably, the special recipe is applied only when Sum(s) is equal to A during a plurality of iterations (=trapping set).

At the first iteration (*it=1*), the control circuit CTRL delivers the first threshold $\theta(1)$ of the threshold sequence. The circuit 700 computes the energy E(j) for the variable node VNj and the comparator circuit 701 compares E(j) with $\theta(1)$. If E(j)>$\theta$ and if the comparator circuit 702 is not activated, then the X-OR gate 704 flips the bit Uj and the flipped bit is stored in the register 705. The multiplexer is then controlled to deliver the content of the register 705. The register 707 is disabled. The output Vj of the variable node VNj is then transmitted to the check nodes connected to it. Other outputs Vk of the other variable nodes VNj are processed in parallel and transmitted to the check nodes connected to them. Sum(S) is computed by the sum circuit SC and transmitted to the control circuit CTRL.

The control circuit compares the value Sum(S) to said at least one predefined value A and activate the comparator circuit 702 if Sum(S) is equal A. Otherwise, the comparator circuit 702 remains deactivated.

The second iteration is then performed with the new parameters issued by the control circuit CTRL and new parity check results $\{S_k\}_{k \in M(j)}$. The energy value E(j) newly computed by the circuit 700 is compared to the second threshold $\theta(2)$ of the threshold sequence.

These operations are repeated until all the check nodes connected to said variable node satisfy the parity check (E(j)=0) or when the number of iterations reach a maximal number of iterations (=number of thresholds in the sequence of thresholds).

If the SBF algorithm comprises a plurality of iterative loops, the different threshold sequences present in a global threshold sequence are for example separated by a negative threshold value (-1) as described above. The control circuit CTRL detects the presence of a negative threshold value in order to reinitialize the bit (to be flipped or not) by the value stored in the register 707.

The comparator circuit 702 is enabled when Sum(S) is blocked to A (trapping set) during a plurality of iterations. In that case, the control circuit CTRL controls the variable node to implement special recipes as mentioned above.

If two successive threshold sequences have common first threshold values, the intermediate result obtained after application of said common first threshold values is stored in the register 706 in order to save time for the execution of the second iterative loop.

Of course, the structures illustrated by Figures 6 and 7 are only given as examples and the scope of the invention is not limited to these examples.

From the above description, it results that the Syndrome Bit Flipping (SBF) shows good performances for decoding LDPC codes having a reduced number of errors. It is used advantageously as post processing method to lower the error floor and increase throughput of bit-flipping LDPC decoders, especially for those based on the GDBF or NGDBF algorithm.

The above description describes embodiments wherein the SBF algorithm are performed after a NGDBF or PGDBF algorithm or a BP algorithm. The SBF algorithm is performed as post processing. The SBF algorithm is for example activated when the number of errors or the number of non-satisfied check nodes falls below a threshold.

Likewise, if the SBF algorithm fails or do not succeed to decrease the number of errors or the number of non-satisfied check nodes, NGDBF, PGDBF or BP algorithm can be reused after SBF.

The present SBF algorithm may be used for regular as well as irregular LDPC codes (each variable node can be connected to a same or a different number of check nodes and vice versa). If the variable nodes have different degrees (= different numbers of check nodes connected to them), the value Sum(S) for a variable node may be weighted as a function of its degree.

Although some embodiments of the present invention have been illustrated in the accompanying Drawings and described in the foregoing detailed description, it should be understood that the present invention is not limited to the disclosed embodiments, but is capable of numerous rearrangements, modifications and substitutions without departing from the invention as set forth and defined by the following claims.

**Claims**

1. Method for controlling a variable node of a decoder for decoding Low-Density Parity-Check codes, called LDPC codes, said variable node storing a current bit of a word to be decoded, said method comprising, at each iteration of an iterative loop, the steps of:

   - receiving (10) information messages emitted by a plurality of check nodes of said decoder, said check nodes being connected to said variable node in accordance with a predetermined decoding structure, each information message emitted by a check node indicating whether said check node satisfies a predetermined parity check or not,
   - deciding (20) if a bit flipping operation is to be applied to the current bit stored in the variable node as a function of the information messages received from the plurality of check nodes connected to said variable node, and
   - applying (30) a bit flipping operation to the current bit of the variable node if a bit flipping operation is decided,

   wherein a bit flipping operation is decided when, among the plurality of check nodes connected to said variable node, the number of check nodes not satisfying said parity check is above a predetermined flipping threshold ($\theta(it)$), a dedicated predetermined flipping threshold being associated to each iteration of the iterative loop such that the predetermined flipping threshold may change from one iteration to another iteration of said iterative loop.

2. Method according claim 1, wherein the iterative loop stops when all the check nodes connected to said variable node satisfy said parity check or when a number of iterations of said iterative loop exceeds a maximal number of iterations.

3. Method according to claim 2, wherein it comprises at least two successive or parallel iterative loops, each iterative loop having a dedicated maximal number of iterations and dedicated predetermined flipping thresholds.

4. Method according to claim 3, wherein it comprises at comprises at least two successive iterative loops, called first and second iterative loops and wherein the first iterative stops when the number of check nodes connected to said node variable and not satisfying said parity check exceeds a predetermined threshold.

5. Method according to any one of claims 1 to 4, wherein a bit flipping operation is also decided as a function of a channel information ($Y_i$) associated with the current bit to be decoded.

6. Method according to any one of claims 1 to 4, wherein the flipping thresholds used in an iterative loop are selected as a function of the number of check nodes of the decoder (Sum(S)) not satisfying said parity check.

7. Variable node in a decoder decoding Low-Density Parity-Check codes, called LDPC codes, said variable node said variable node storing a current bit of a word to be decoded, said variable node being configured to implement, at each iteration of an iterative loop, the steps of:

   - receiving information messages emitted by a plurality of check nodes of said decoder, said check nodes being connected to said variable node in accordance with a predetermined decoding structure, each information message emitted by a check node indicating whether said check node satisfies a predetermined parity check or not,
   - deciding if a bit flipping operation is to be applied to the current bit stored in the variable node as a function of the information messages received from the plurality of check nodes connected to said variable node, and
   - applying a bit flipping operation to the current bit of the variable node if a bit flipping operation is decided,

   wherein a bit flipping operation is decided when, among the plurality of check nodes connected to said variable node, the number of check nodes not satisfying said parity check is above a predetermined flipping threshold ($\theta(it)$), a dedicated predetermined flipping threshold being associated to each iteration of the iterative loop such that the predetermined flipping threshold may change from one iteration to another iteration of said iterative loop.

8. Variable node according claim 7, wherein the iterative loop stops when all the check nodes connected to said variable node satisfies said parity check or when a number of iterations of said iterative loop exceeds a maximal number of iterations.

9. Variable node according to claim 8, wherein it comprises at least two successive or parallel iterative loops, each iterative loop having a dedicated maximal number of iterations and dedicated predetermined flipping thresholds.

10. Variable node according to claim 9, wherein it comprises at comprises at least two successive iterative loops, called first and second iterative loops and wherein the first iterative stops when the number of check nodes connected to said variable node and not satisfying said parity check exceeds a predetermined threshold.

11. Variable node according to any one of claims 7 to 10, wherein a bit flipping operation is also decided as a function of a channel information associated with the current bit to be decoded.

12. Variable node according to any one of claims 7 to 11, wherein the flipping thresholds used in an iterative loop are selected as a function of the number of check nodes of the decoder not satisfying said parity check.

13. Decoder for decoding LDPC codewords comprising a plurality of check nodes and a plurality of variable nodes according to any one of claims 7 to 12.

14. Computer program product comprising program code instructions for implementing the method according to any one of claims 1 to 6, when said program is executed on a computer or a processor

15. Non-transitory computer-readable storage medium storing a computer program product according to claim 14.

Figure 1

Figure 2

Figure 3

Figure 4

Figure 5

**Figure 6**

Figure 7

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/229792 A1 (VARNICA NEDELJKO [US] ET AL) 14 August 2014 (2014-08-14) | 1,3,5,7, 9,11, 13-15 | INV. H03M13/11 H03M13/37 |
| A | * abstract * * figures 2A,2B * * paragraph [0043] - paragraph [0056] * | 4,6,10, 12 | |
| X | JUNHO CHO ET AL: "Adaptive Threshold Technique for Bit-Flipping Decoding of Low-Density Parity-Check Codes", IEEE COMMUNICATIONS LETTERS, IEEE SERVICE CENTER, PISCATAWAY, NJ, US, vol. 14, no. 9, 1 September 2010 (2010-09-01), pages 857-859, XP011316011, ISSN: 1089-7798 | 1-3,7-9, 13-15 | |
| A | * the whole document * | 4,6,10, 12 | |
| X | JULIAN WEBBER ET AL: "Investigation of simple threshold shifting for bit-flip decoding", PROC., IEEE 14TH INTERNATIONAL SYMPOSIUM ON WIRELESS PERSONAL MULTIMEDIA COMMUNICATIONS (WPMC), 2011, 3 October 2011 (2011-10-03), pages 1-5, XP032010347, ISBN: 978-1-4577-1786-4 | 1-3,5, 7-9,11, 13-15 | TECHNICAL FIELDS SEARCHED (IPC) H03M |
| A | * the whole document * | 4,6,10, 12 | |
| X | US 2004/148561 A1 (SHEN BA-ZHONG [US] ET AL) 29 July 2004 (2004-07-29) | 1,2,7,8, 13-15 | |
| A | * paragraph [0125] - paragraph [0146]; figures 9, 13A, 13B * | 4,6,10, 12 | |

-/--

The present search report has been drawn up for all claims

| Place of search | Date of completion of the search | Examiner |
|---|---|---|
| Munich | 10 September 2018 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 18 30 5269

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 643 653 A1 (LUCENT TECHNOLOGIES INC [US]) 5 April 2006 (2006-04-05) | 1,2,7,8, 13-15 | |
| A | * the whole document * | 4,6,10, 12 | |
| | ----- | | |
| X | YU KOU ET AL: "Low-Density Parity-Check Codes Based on Finite Geometries: A Rediscovery and New Results", IEEE TRANSACTIONS ON INFORMATION THEORY, IEEE PRESS, USA, vol. 47, no. 7, 1 November 2001 (2001-11-01), XP011028087, ISSN: 0018-9448 | 1,2,5,7, 8,11, 13-15 | |
| A | * page 2718 - page 2720 * | 4,6,10, 12 | |
| | ----- | | |

TECHNICAL FIELDS
SEARCHED      (IPC)

The present search report has been drawn up for all claims

| Place of search | Date of completion of the search | Examiner |
|---|---|---|
| Munich | 10 September 2018 | Offer, Elke |

EPO FORM 1503 03.82 (P04C01)

**ANNEX TO THE EUROPEAN SEARCH REPORT
ON EUROPEAN PATENT APPLICATION NO.**

EP 18 30 5269

This annex lists the patent family members relating to the patent documents cited in the above-mentioned European search report.
The members are as contained in the European Patent Office EDP file on
The European Patent Office is in no way liable for these particulars which are merely given for the purpose of information.

10-09-2018

| Patent document cited in search report | | Publication date | Patent family member(s) | | Publication date |
|---|---|---|---|---|---|
| US 2014229792 | A1 | 14-08-2014 | CN | 104995844 A | 21-10-2015 |
| | | | US | 2014229792 A1 | 14-08-2014 |
| | | | WO | 2014126750 A1 | 21-08-2014 |
| US 2004148561 | A1 | 29-07-2004 | NONE | | |
| EP 1643653 | A1 | 05-04-2006 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. SUNDARARAJAN ; C. WINSTEAD ; E. BOUTILLON.** Noisy Gradient Descent Bit-Flip Decoding for LDPC Codes. *IEEE Transactions on Communications,* October 2014, vol. 62 (10), 3385-3400
- **O.A. RAHEED ; P. IVANIS ; B. VASIC.** Fault-Tolerant Probabilistic Gradient-Descent Bit Flipping Decoder. *IEEE Communications Letters,* September 2014, vol. 18 (9), 1487-1490
- **Z.ZHANG ; L.DOLECEK ; B.NIKOLIC ; V.ANANTHARAM ; M.J.WAINWRIGHT.** Design of ldpc decoders for improved low error rate performance: quantization and algorithm choices. *IEEE Transactions on Communications,* November 2009, vol. 57 (11), 3258-3268